# EUROPEAN PATENT APPLICATION

(11) **EP 4 589 655 A1**
(43) Date of publication of application: **23.07.2025**
(21) Application number: 24152982.5
(22) Date of filing: 19.01.2024
(51) Int. Cl.: H01L 23/495, H01L 23/00

(54) **CLIP**

(71) Applicant: Nexperia B.V., 6534 AB Nijmegen (NL)
(72) Inventor: Dchar, Ilyas, 6534AB Nijmegen (NL); Yandoc, Ricardo, Manchester, SK7 5BJ (GB); Brown, Adam, Manchester, SK7 5BJ (GB); Chimmineni, Balakrishna, Manchester (GB)
(74) Representative: Pjanovic, Ilija

(57) **Abstract**

A clip for a semi-conductor device is provided. The clip comprises a first portion, and a second portion. The second portion is connected to the first portion. The first portion is formed of a laminate structure that comprises a first layer and second layer. A first side of the second layer is secured to a first side of the first layer. The first layer is formed from copper. The second layer is formed from a non-copper material having a coefficient of thermal expansion that is less than a coefficient of thermal expansion of the first layer. The second portion is formed from copper only.

## Description

### Field of Invention

The present invention relates to a clip for a semi-conductor device, and to a semi-conductor device that comprises the clip.

### Background

Semiconductor assemblies, such as transistors, are manufactured as layered assemblies including components such as die paddles, dies, clips and a casing. The casing provides a protective functionality and at least partially surrounds the die and other components that form a part of the semiconductor assembly.

Semiconductor assemblies, which are often referred to as 'packages', are subject to temperature fluctuations in use. These temperature fluctuations result in the expansion and contraction of the components of the package, which include one or more dies, one or more clips, a lead frame, and a mould compound (also referred to as a cover or encapsulant). The coefficient of thermal expansion of each component varies, and so the amount by which each component expands and contracts as a result of temperature changes also varies. This leads to internal stresses accumulating within the components of the package. The internal stresses are undesirable because they can result in delamination of the components of the package such as the clip and/or mould compound, solder wear-out, cracking of the die, warpage. Other causes of delamination of the components of the package exist.

There exists a need to overcome the disadvantages associated with existing semiconductor assemblies, and clips for semi-conductor assemblies, whether mentioned in this document or otherwise.

### Summary

In a first aspect of the invention there is provided a clip for a semi-conductor device. The clip comprising a first portion, and a second portion. The second portion is connected to the first portion. The first portion is formed of a laminate structure that comprises a first layer and second layer. A first side of the second layer is secured to a first side of the first layer. The first layer is formed from copper and the second layer is formed from a non-copper material having a coefficient of thermal expansion that is less than a coefficient of thermal expansion of the first layer. The second portion is formed from copper only.

The second portion may be formed from a single piece of copper.

The second portion may comprise a plurality of leads.

The second layer being formed from a non-copper material may be understood to mean that at least part of the second layer is formed from a non-copper material. An area of a footprint of the non-copper material may be less than an area of a footprint of the first layer.

Since a number of different copper grades are available, the coefficient of thermal expansion of the copper layer may be understood to refer to the coefficient of thermal expansion of the relevant grade of copper.

Since the first portion is formed from a laminate structure that includes a first layer formed from copper and a second layer that is formed from a material having a lower coefficient of thermal expansion than the first layer, the effective coefficient of thermal expansion of the first portion of the clip is reduced. This is as compared to if the first portion were made from copper only. The term `effective coefficient of thermal expansion' of the first portion may be understood to refer to the coefficient of thermal expansion of the first portion where the first portion is treated as though it were made of a single layer of a material. Reducing the effective coefficient of thermal expansion is desirable because doing so brings the effective coefficient of thermal expansion closer to the coefficient of thermal expansion of a semi-conductor die to which the clip is secured in use. This reduces the stresses that result from heating of the clip in use. These stresses can result in damage to the clip, to the other component(s) of the semi-conductor device to which the clip is secured, or to an adhesive used to secure the clip to the other component(s) of the semi-conductor device.

To manufacture the clip, a piece of material is stamped from a sheet and is subsequently formed into shape by bending. These processes present a risk of damage to the portions of the clip to which they are being performed. This risk is heightened where the relevant portion is formed of a laminated structure. Since the second portion is formed from copper only, the likelihood of the clip being damaged during manufacture is advantageously reduced. This is because the bending can take place in the region of the second portion.

A ratio of a thickness of the first layer to a thickness of the second layer may be at least 1 and/or up to 5.

The ratio of a thickness of the first layer to a thickness of the second layer may be calculated by dividing the thickness of the second layer by the thickness of the first layer.

The presence of the non-copper second layer affects not only the effective coefficient of thermal expansion, but also the thermal and electrical conductivity of the first portion. In particular, the thermal and electrical conductivity of the first portion are reduced by the non-copper second layer. Where a ratio of a thickness of the first layer to a thickness of the second layer is at least 1 and/or up to 5, the effective coefficient of thermal expansion, the thermal conductivity, and the electrical conductivity of the first portion can be optimised such that the performance of the clip can be optimised.

An area of a footprint of the first layer may be equal to an area of a footprint of the second layer.

Where an area of a footprint of the first layer is equal to an area of a footprint of the second layer, the contact area between the first layer and the second layer is increased. This is as compared to if an area of the second layer were less than an area of the first layer. Increasing the contact area between the first layer and the second layer better distributes the stress that the clip is subject to in use. This further reduces the likelihood of separation of the clip from the semi-conductor die to which it is secured in use, and reduces the likelihood of cracking of the adhesive used to secure the clip to the semi-conductor die.

The second layer may be formed from one of molybdenum, a molybdenum-copper alloy, or a nickel-iron alloy.

The nickel-iron alloy may be Invar.

The laminate structure may further comprise a third layer that is formed from copper. A first side of the third layer may be secured to a second side of the second layer. The second side of the second layer may be opposed to the first side of the second layer.

Where the laminate structure further comprises a third layer, the ability of the clip to absorb stress in use is further improved. This is because the third layer allows the clip to deform as a result of temperature fluctuations more uniformly.

A thickness of the third layer may be substantially equal to a thickness of the second layer.

An area of a footprint of the third layer may be equal to an area of a footprint of the second layer.

The laminate structure may further comprise a fourth layer that is formed from a non-copper material. The non-copper material of the fourth layer may have a coefficient of thermal expansion that is less than the coefficient of thermal expansion of the first layer and of the third layer. A first side of the fourth layer may be secured to a second side of the third layer. The second side of the third layer may be opposed to the first side of the third layer.

The fourth layer may be formed from one of molybdenum, a molybdenum-copper alloy, or a nickel-iron alloy.

The material of the fourth layer may be the same as, or different to, the material of the second layer.

The laminate structure may further comprise a fifth layer that is formed from copper. A first side of the fifth layer may be secured to a second side of the fourth layer. The second side of the fourth layer may be opposed to the first side of the fourth layer.

The first portion and the second portion may be non-coplanar. The first portion and the second portion may be connected via a transition portion. The transition portion may be formed from copper only.

In a second aspect of the invention there is provided a semi-conductor device. The semi-conductor device comprises a lead frame, a semi-conductor die mounted on the lead frame, and a clip according to the first aspect of the invention. The first portion of the clip is secured to the semi-conductor die. The semi-conductor device further comprises a cover that at least partially surrounds the lead frame, the semi-conductor die, and the clip.

A second side of the first layer of the laminate structure may be secured to the semi-conductor die. The second side of the first layer may be opposed to the first side of the first layer.

Since the effective coefficient of thermal expansion of the clip is reduced, the likelihood of separation of the cover and the clip is also reduced. This is because the effective coefficient of thermal expansion of the clip is closer to the coefficient of thermal expansion of the cover as a result of the second layer of the laminate structure. Therefore, the difference in the amount by which the clip and cover deform in use is reduced, which reduces the stresses at the interface between the clip and the cover. Reducing the stresses at the interface between the clip and cover advantageously reduces the likelihood of separation of the cover and the clip.

The semi-conductor die may comprise an active element that comprises silicon carbide or gallium nitride.

The advantageous effects of the present invention are particularly beneficial for dies made of these materials. This is because these materials are more brittle than, for example, silicon.

The semi-conductor die may be said to be formed at least in part of silicon carbide or gallium nitride.

The active element may be said to be formed of silicon carbide or gallium nitride.

The active element may comprise silicon.

The semi-conductor device may comprises a plurality of clips according to the first aspect of the invention. The semi-conductor device may be a two-terminal device or a three-terminal device, based on the number of clips provided.

### Brief Description of the Drawings

Embodiments of the present invention will now be discussed with reference to the accompanying drawings, in which:
Figure 1 shows a perspective view of a semi-conductor device according to an first embodiment;
Figure 2 shows a side view of the device of Figure 1;
Figure 3 shows an exploded view of a portion of a clip of the device of Figure 1;
Figure 4 shows an exploded view of a portion of a modified clip for the device of Figure 1;
Figure 5 shows a side view of a sheet used to manufacture the clip of the first embodiment; and
Figure 6 shows a semi-conductor device according to a second embodiment.

### Detailed Description

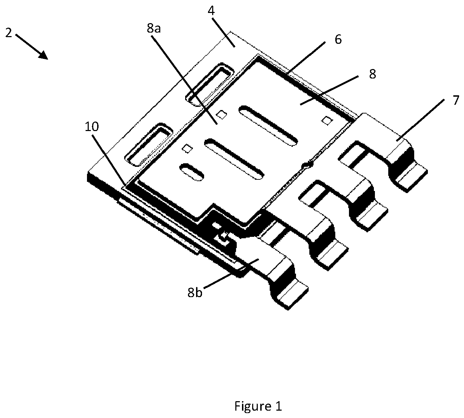

Figure 1 shows a semiconductor device 2. The semi-conductor device 2 comprises a lead frame 4. The semi-conductor device 2 comprises a die 6. The semi-conductor device 2 comprises a clip 8. The semi-conductor device 2 comprises a cover (not shown in Figure 1).

The lead frame 4 serves as a base of the semi-conductor device 2 to which other components of the device are attached. The lead frame 4 is manufactured from a conductive material such as copper (including a copper alloy).

The die 6 is secured to the lead frame 4. The die 6 is secured to the lead frame 4 by virtue of a first solder layer 10. The die 6 may be a single component or may comprise multiple constituent components. The die 6 is made of a semi-conducting material. For example, the die 6 may be made from silicon carbide or gallium nitride, or any other suitable material. The die 6 has a functional circuit fabricated thereon. The die 6 is generally rectangular but may be any other suitable shape. The die 6 is plate like in shape.

In the embodiment shown in Figure 1, the clip 8 comprises two constituent parts 8a, 8b, such that the device 2 is a three terminal device. However, in some embodiments, the clip 8 may comprise any suitable number of constituent parts. For example, the clip 8 may comprise only a single constituent part such that the device 2 is a two terminal device.

The cover encapsulates the remaining components of the semi-conductor device 2 (i.e., the lead frame 4, the die 6, and the clip 8). The cover may also be referred to as an isolator, a casing, or an encapsulant. A plurality of leads 7 (only one of which is labelled in Figure 1) of the clip 8 extend through the cover. This allows the leads 7 to be connected to the external circuit (not shown). The cover may be made from any suitable electrically isolating material, such as an epoxy.

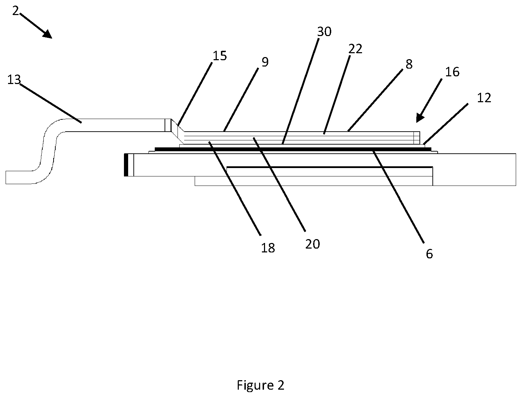

Referring now to Figure 2. The clip 8 is secured to the die 6. The clip 8 is secured to the die 6 by virtue of a second solder layer 12. In particular, the first portion 9 of the clip 8 is secured to the die 6 by virtue of the second solder layer 12.

The clip 8 comprises a first portion 9, a second portion 13, and a transition portion 15. The transition portion 15 adjoins and is disposed between the first portion 9 and the second portion 13. At least part of the transition portion 15 is integrally formed with at least part of the first portion 9 and the second portion 13, as will be discussed in more detail below. The transition portion 15 is formed from copper only. In some embodiments, the transition portion 15 may be separately formed from the first portion 9 and/or from the second portion 13. The second portion 13 comprises the plurality of leads 7. The second portion is formed from copper only. At least part of the second portion is integrally formed with at least part of the transition portion 15 and with at least part of the first portion 9. In some embodiments, the second portion 13 may be separately formed from the transition portion 15. In some embodiments, the second portion 13 may be separately formed from the transition portion 15 and from the first portion 9. The second portion 13 is connected to the transition portion 15. Therefore, the second portion 13 is connected to the first portion 9 (via the transition portion). The first portion 9 and the second portion 13 are non-coplanar. In some embodiments, the first portion 9 and the second portion 13 may be coplanar, in which case the transition portion 15 need not be provided.

The first portion 9 is formed of a laminate structure 16. The term `laminate structure' may be understood to refer to a structure that is formed of multiple layers of material that are bonded or otherwise adhered to one another. The laminate structure 16 comprises a first layer 18, a second layer 20, and a third layer 22. In some embodiments the third layer 22 need not be provided. The first layer is formed from copper. The second layer is formed from a non-copper material that has a coefficient of thermal expansion that is less than a coefficient of thermal expansion of the first layer. The third layer 22 is formed from copper. It is the first layer 18 of the laminate structure 16 that is secured to the die 6 by virtue of the second solder layer 12. The second layer may be formed from one of molybdenum, a molybdenum-copper alloy, or a nickel-iron alloy.

Since the second layer 20 is formed from a non-copper material that has a coefficient of thermal expansion that is less than that of copper, the effective coefficient of thermal expansion of the first portion 9 of the clip 8 is reduced. Dies for semi-conductor devices typically are made of materials having a lower coefficient of thermal expansion than copper. Since the effective coefficient of thermal expansion of the first portion 9 of the clip 8 is reduced, the likelihood of separation of the first portion 9 of the clip 8 from the die 6 is also reduced.

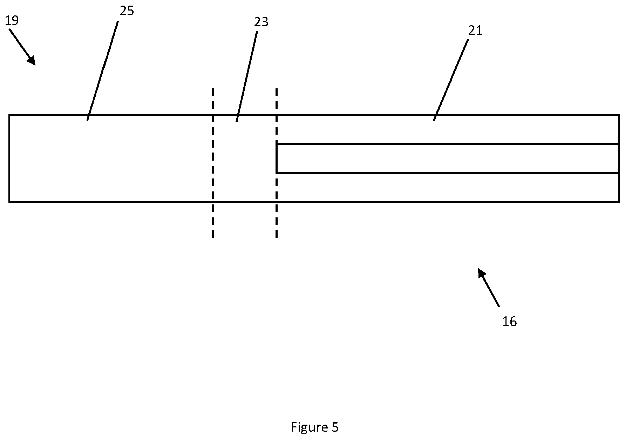

Manufacture of the clip 8 will now be described with reference to Figure 5. An unformed sheet 19 is provided. The sheet 19 being unformed refers to the sheet being unformed (i.e., generally plate-shaped). The unformed sheet 19 comprises a first segment 21, a second segment 23, and a third segment 25. The first segment 21 corresponds with the first portion of the clip. The second segment 23 corresponds with the transition portion of the clip. The third segment 25 corresponds with the second portion of the clip. The second segment 23 and the third segment 25 may also be formed of a laminated structure that comprises a number of layers that corresponds to the number of layers of the laminated structure 16 of the first segment 21 (and therefore of the first portion of the clip). At least one of the layers of the laminated structure of the second segment 23 and of the third segments 25 may extend continuously from at least one of the layers of the laminated structure 16 of the first segment 21.

In some embodiments, the second segment 23 and/or the third segment 25 need not be formed from a laminated structure, but may be each formed from a single block of material. Where this is the case, the second segment 23 and/or the third segment 25 may be attached to the first segment 21 via any suitable process.

Referring back to Figure 2, the shape of the clip 8 is then formed. To form the clip 8, a piece of material is stamped from the sheet and is subsequently formed into shape. This introduces a risk of damage to the portions of the clip to which they are being performed. This risk is heightened by a laminated structure. However, since the transition portion 15 and the second portion 13 are formed from copper only, the likelihood of damage occurring to the clip 8 is reduced. This makes manufacture of the clip 8 more efficient.

A thickness of the first layer 18 is equal to a thickness of the second layer 20. However, a ratio of the thickness of the first layer 18 to the thickness of the second layer 20 may be at least one and/or up to five. The ratio of the thickness of the first layer 18 to the thickness of the second layer 20 may be calculated by dividing the thickness of the second layer 20 by the thickness of the first layer 18. Since the second layer 20 is formed from a non-copper material having a coefficient of thermal expansion that is less than that of copper, the effective coefficient of thermal expansion of the first portion 9 of the clip 8 is advantageously reduced. However, the thermal conductivity and electrical conductivity of the first portion 9 is also reduced therefore the thickness of the second layer 20 can be optimised so as to optimise the balance of the coefficient of thermal expansion on the one hand and the electrical and the thermal conductivities on the other hand.

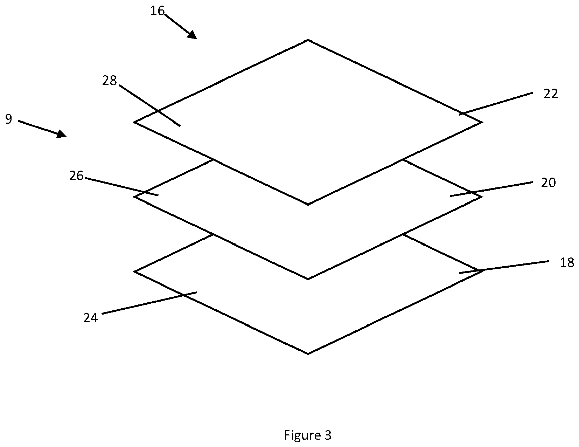

Figure 3 shows an exploded view of the laminate structure 16 of the first portion 9. A first side of the second layer 20 is secured to a first side 24 of the first layer 18. The first side of the second layer 20 is not visible in Figure 3 because it is behind a second side 26 of the second layer 20. A first side of the third layer 22 is secured to the second side 26 of the second layer 20. The first side of the third layer is not visible in Figure 3 because it is hidden behind a second side 28 of the third layer 22. In this embodiment, the second side 28 of the third layer 22 defines an upper surface of the laminate structure 16, and so defines an upper surface of the first portion 9. Here and throughout this document a side of a layer may be understood to refer to a major surface of that layer. The first side, or major surface, of each layer is generally opposed to the second side of that layer. The layers of the laminate structure 16 may be secured to one another via roll bonding. Roll bonding is a procedure in which heat and pressure is applied to layers of materials so as to secure them to one another.

Referring to Figure 2, it is the second side 30 of the first layer 18 that contacts the second solder layer 12 to secure the first portion 9 of the clip 8, and the clip 8 as a whole, to the die 6.

Referring back to Figure 3, an area of the footprint of the first layer 18 is generally equal to an area of a footprint of the second layer 20. The term area of the footprint may be understood to refer to an area of that portion when viewed in plan view. An area of the footprint of the third layer is equal to an area of a footprint of the second layer. The area of the footprint of the first layer 18 being equal to the area of the footprint of the second layer 20, and the area of the footprint of the third layer 22 being equal to the area of the footprint of the second layer advantageously better distributes the stress that the clip 8 is subject to in use. This reduces the likelihood of delamination of the layers 18, 20, 22.

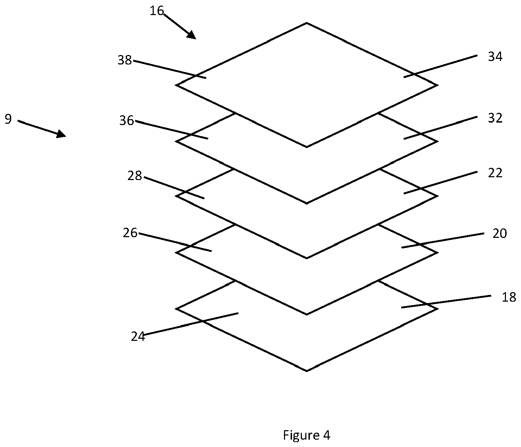

In the embodiment shown in Figure 4 the laminate structure 16 further comprises a fourth layer 32 and a fifth layer 34. The fourth layer 32 is formed from a non-copper material that has a coefficient of thermal expansion that is less than that of copper. Preferably, the fourth layer is formed from one of molybdenum, a molybdenum-copper alloy, or a nickel-iron alloy. The fifth layer 34 is formed from copper. A first side of the fourth layer 32 is secured to the second side 28 of the third layer 22. The first side of the fourth layer 32 is not visible in Figure 4 because it is behind a second side 36 of the fourth layer 32. A first side of the fifth layer 34 is secured to the second side 36 of the fourth layer 32. The first side of the fifth layer 34 is not visible in Figure 4 because it is behind a second side 38 of the fifth layer 34.

An area of a footprint of the fourth layer 32 is generally equal to the area of the footprint of the third layer 22. An area of a footprint of the fifth layer is generally equal to the area of the footprint of the fourth layer. The thickness of the fourth layer is equal to the thicknesses of the first layer 18, the second layer 20, the third layer 22, and the fifth layer 34. However, in some embodiments, the thickness of the fourth layer 32 may be at least equal to the thicknesses of the other layers of the laminate structure 16 and/or up to five times greater than the thicknesses of the other layers of the laminate structure. In some embodiments, the fifth layer 34 need not be provided.

In some embodiments, at least part of the second layer 20 and/or at least part of the fourth layer 32 (where provided) may be formed from copper. The following description will be in relation to the second layer, but applies equally to the fourth layer. Where at least part of the second layer 20 is formed from copper, the remainder of the second layer 20 is formed from one of molybdenum, a molybdenum-copper alloy, or a nickel-iron alloy (referred to as the non-copper portion). An area of a footprint of the non-copper material of the second layer 20 may be less than an area of a footprint of the first layer 9. The non-copper portion may be in the form of a strip. The strip may be offset from a periphery of the first portion 9, preferably with the exception of the ends of the strip, which may adjoin the periphery of the first portion 9. Alternatively, the strip may extend along and adjoin a periphery of the first portion (i.e., a long edge of the strip may adjoin the periphery of the first portion 9). The strip may have any suitable orientation. A plurality of non-copper strips may be provided. The plurality of non-copper strips may comprises two strips. Each strip may be offset from the periphery of the first portion 9, preferably with the exception of the ends of the strip, which may adjoin the periphery of the first portion 9. Alternatively, the plurality of strips may extend along and adjoin the periphery of the first portion 9 (i.e., a long edge of each strip may adjoin a peripheral portion of the first portion). The number of, position, and orientation of the one or more strips may be chosen to optimise the balance of the effective coefficient of thermal expansion of the first portion 9, the thermal conductivity of the first portion 9, and the electrical conductivity of the first portion 9. The configuration of the first portion 9 can be formed while roll bonding the clip 8.

It will be appreciated that the method for manufacturing the clip 8 using the laminate structure 16 of Figure 4 corresponds with the method discussed above in relation to the three layer laminate structure 16.

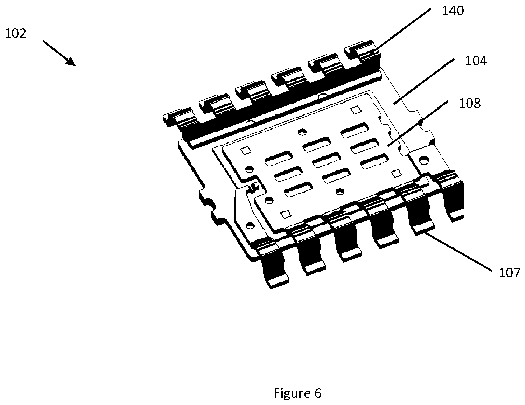

Figure 6 shows a further embodiment of a semiconductor device 102. In this embodiment, the device 102 comprises a second plurality of leads 140. The second plurality of leads 140 are separately formed from the clip 108. The second plurality of leads 140 allow electrical communication between the lead frame 104 and an external circuit (such as a printed circuit board). This is alternative to mounting the lead frame 104 on the external circuit board directly (e.g., via a solder layer). The second plurality of leads 140 also serve to absorb mechanical stresses that the device 102 may be subject to in use. Although the device 102 of Figure 5 is a three-terminal device, the teachings of this embodiment are applicable to a two-terminal device.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A clip for a semi-conductor device, the clip comprising:
a first portion, and a second portion, the second portion being connected to the first portion;
wherein the first portion is formed of a laminate structure that comprises a first layer and second layer, a first side of the second layer being secured to a first side of the first layer;
wherein the first layer is formed from copper and the second layer is formed from a non-copper material having a coefficient of thermal expansion that is less than a coefficient of thermal expansion of the first layer; and
wherein the second portion is formed from copper only.

2. The clip of claim 1, wherein a ratio of a thickness of the first layer to a thickness of the second layer is at least 1 and/or up to 5.

3. The clip of any claim 1 or claim 2, wherein an area of a footprint of the first layer is equal to an area of a footprint of the second layer.

4. The clip of any preceding claim, wherein the second layer is formed from one of molybdenum, a molybdenum-copper alloy, or a nickel-iron alloy.

5. The clip of any preceding claim, wherein the laminate structure further comprises a third layer that is formed from copper, a first side of the third layer being secured to a second side of the second layer, the second side of the second layer being opposed to the first side of the second layer.

6. The clip of claim 5, wherein a thickness of the third layer is substantially equal to a thickness of the second layer.

7. The clip of claim 5 or claim 6, wherein an area of a footprint of the third layer is equal to an area of a footprint of the second layer.

8. The clip of any preceding claim, wherein the laminate structure further comprises a fourth layer that is formed from a non-copper material having a coefficient of thermal expansion that is less than the coefficient of thermal expansion of the first layer and of the third layer, a first side of the fourth layer being secured to a second side of the third layer, the second side of the third layer being opposed to the first side of the third layer.

9. The clip of claim 7, wherein the fourth layer is formed from one of molybdenum, a molybdenum-copper alloy, or a nickel-iron alloy.

10. The clip of claim 8 or claim 9, wherein the laminate structure further comprises a fifth layer that is formed from copper, a first side of the fifth layer being secured to a second side of the fourth layer, the second side of the fourth layer being opposed to the first side of the fourth layer.

11. The clip of any preceding claim, wherein the first portion and the second portion are non-coplanar and are connected via a transition portion, and wherein the transition portion is formed from copper only.

12. A semi-conductor device comprising:
a lead frame;
a semi-conductor die mounted on the lead frame;
a clip according to any preceding claim, wherein the first portion of the clip is secured to the semi-conductor die; and
a cover that at least partially surrounds the lead frame, the semi-conductor die, and the clip.

13. The semi-conductor device of claim 12, wherein the semi-conductor die comprises an active element that comprises silicon carbide or gallium nitride.

14. The semi-conductor device of claim 12 or claim 13, wherein the semi-conductor device comprises a plurality of clips according to any of claims 1 to 11 such that the semi-conductor device is a two-terminal device or a three-terminal device.
